# FASCICULE DE BREVET EUROPEEN

(11) **EP 2 534 276 B1**
(45) Date de publication et mention de la délivrance du brevet: **11.03.2015**
(21) Numéro de dépôt: 11708917.7
(22) Date de dépôt: 10.02.2011
(51) Int. Cl.: C23C 14/06, A47J 27/00

(54) **SURFACE DE CUISSON FACILE À NETTOYER ET ARTICLE CULINAIRE OU APPAREIL ELECTROMENAGER COMPORTANT UNE TELLE SURFACE DE CUISSON**
LEICHT ZU REINIGENDE KOCHPLATTE UND KÜCHENGERÄT ODER ELEKTRISCHER HAUSHALTSARTIKEL MIT EINER SOLCHEN KOCHPLATTE
EASY-CLEAN COOKING SURFACE AND CULINARY ARTICLE OR DOMESTIC ELECTRICAL APPLIANCE COMPRISING SUCH A COOKING SURFACE

(30) Priorité: 12.02.2010 FR 1000583
(43) Date de publication de la demande: 19.12.2012
(73) Titulaire: SEB S.A., 69130 Ecully (FR); Université de Lorraine, 54052 Nancy Cedex (FR); Centre National de la Recherche Scientifique, 75794 Paris Cedex 16 (FR)
(72) Inventeur: TUFFE, Stéphane, F-73160 Cognin (FR); PIERSON, Jean-François, F-54042 Nancy Cedex (FR)
(74) Mandataire: Cémeli, Eric Philippe Laurent
(86) Numéro de dépôt international: PCT/FR2011/050278
(87) Numéro de publication internationale: WO 2011/098730

(56) Documents cités:
- FR-A1- 2 897 250
- DATABASE CA [Online] CHEMICAL ABSTRACTS SERVICE, COLUMBUS, OHIO, US; 19 février 2009 (2009-02-19), YU, LIHUA ET AL: "Zr-Si-N hard composite coating and preparation method thereof", XP002603398, extrait de STN Database accession no. 150:174367 & CN 101 338 411 A (JIANGSU UNIVERSITY OF SCIENCE AND TECHNOLOGY, PEOP. REP. CHINA) 7 janvier 2009 (2009-01-07)
- SANDU C S ET AL: "Formation of composite ternary nitride thin films by magnetron sputtering co-deposition", SURFACE AND COATINGS TECHNOLOGY, ELSEVIER, AMSTERDAM, NL LNKD- DOI:10.1016/J.SURFCOAT.2006.08.100, vol. 201, no. 7, 20 décembre 2006 (2006-12-20), pages 4083-4089, XP024995943, ISSN: 0257-8972 [extrait le 2006-12-20]
- PILLOUD D ET AL: "Structure and tribological properties of reactively sputtered Zr-Si-N films", THIN SOLID FILMS, ELSEVIER-SEQUOIA S.A. LAUSANNE, CH LNKD- DOI:10.1016/J.TSF.2005.09.062, vol. 496, no. 2, 21 février 2006 (2006-02-21), pages 445-449, XP025006665, ISSN: 0040-6090 [extrait le 2006-02-21]

## Description

La présente invention concerne le domaine des articles culinaires et des appareils électroménagers destinés à la cuisson des aliments, et plus particulièrement la surface de cuisson de ces articles culinaires ou appareils électroménagers en contact avec les aliments à traiter.

La présente invention vise à l'amélioration des surfaces de cuisson à base de dépôts de Ti, Zr, Nb, sous forme de carbures, nitrures ou carbonitrures, tels notamment celles décrites dans les demandes de brevet FR 2848797, FR 2883150 et FR 2897250 au nom du présent déposant.

De telles surfaces de cuisson présentent notamment la propriété d'être faciles à nettoyer après leur utilisation en tant que surface de cuisson d'aliments, cette facilité de nettoyage pouvant être exprimée par la possibilité d'enlever facilement des éléments carbonisés sur la surface de cuisson.

Des phénomènes de tachage ont toutefois été observés sur de telles surfaces de cuisson au contact de certains aliments. Ces phénomènes de tachage ont lieu sur des dépôts présentant des structures et des compositions variées, sans que la préparation de surface effectuée avant lesdits dépôts ne modifie l'apparition et/ou l'ampleur de ces taches.

Des analyses de ce phénomène montrent notamment que de telles taches se forment essentiellement lors de cuisson avec des graisses animales, par réaction des graisses avec la surface et/ou par oxydation de la surface.

La présente invention vise à réduire considérablement l'apparition de ces taches par une augmentation de la résistance à l'oxydation de tels revêtements, sans dégrader les propriétés de facilité de nettoyage propres à ces surfaces.

La présente invention est atteinte à l'aide d'une surface de cuisson d'aliments pour article culinaire ou appareil électroménager de cuisson, consistant en un dépôt de Zr et/ou Nb et/ou Ti sur un substrat, sous forme de carbures, nitrures ou carbonitrures pour au moins l'un des éléments, du fait que la surface de cuisson comporte également un dépôt de Si afin de réaliser des revêtements (Zr/Nb/Ti)-Si-(N/C).

Par l'expression « revêtement (Zr/Nb/Ti)-Si-(N/C) », on entend un revêtement à base de Zr et/ou Nb et/ou Ti, comportant également l'élément Si, une étape de nitruration et/ou de carburation ayant lieu pendant ou après le dépôt des éléments mentionnés.

Ainsi, la présente invention se propose d'améliorer l'inertie chimique des couches connues à base de Zr et/ou Nb et/ou Ti sous forme de carbures, nitrures ou carbonitrures, en tant que surface de cuisson, par adjonction de silicium au cours de l'élaboration.

Différentes études et analyses ont en effet montré que les taches sont fortement atténuées, voire inexistantes, selon les conditions d'élaboration, par la présence de silicium dans la surface de cuisson.

Par ailleurs, différents essais ont montré que l'ajout de silicium permet également d'augmenter la dureté, donc la résistance aux rayures, ainsi que les propriétés d'adhésion des couches élaborées.

De manière surprenante, l'ajout de silicium, non seulement n'a pas dégradé l'aptitude de ces couches à être facilement nettoyées après leur utilisation en tant que surface de cuisson, mais a même renforcé cette propriété, améliorant ainsi considérablement les différentes qualités de ces couches, au-delà du but initialement recherché.

Selon un mode préféré d'élaboration, les dépôts sont réalisés par dépôt physique en phase vapeur, usuellement dénommé PVD. Le dépôt physique en phase vapeur est un procédé connu de dépôt de matériaux, présentant l'avantage d'utiliser peu de matière et de pouvoir ajuster une faible épaisseur de matériau sur le substrat en vue de réaliser la surface de cuisson, diminuant ainsi le coût en matière première de ces matériaux. Cette technique de dépôt permet, par ailleurs, d'obtenir des dépôts de forte adhésion avec le substrat sur lequel ils sont déposés. Les risques de décollement du dépôt au cours de l'utilisation sont ainsi minimisés. Cet aspect est d'importance puisque la surface de cuisson doit résister aux sollicitations mécaniques engendrées par l'utilisation de fourchettes, couteaux et autres accessoires de cuisine lors de la manipulation des aliments dans un ustensile de cuisson tel qu'un article culinaire ou un appareil électroménager de cuisson comportant ladite surface de cuisson.

Avantageusement, le dépôt est réalisé en condition réactive, c'est-à-dire en présence de gaz réactif tel que l'azote, l'acétylène, le méthane,... afin d'accomplir, pendant l'étape de dépôt, l'étape de carburation et/ou de nitruration, permettant de réduire le temps de traitement, tout en augmentant la dureté des revêtements.

Avantageusement, le dépôt de Si est réalisé dans la même étape de dépôt que le dépôt de Zr et/ou Nb et/ou Ti, afin également de rationaliser les coûts et la durée des dépôts.

Selon une mise en oeuvre préférée de l'invention, la surface de cuisson consiste en un dépôt de (Zr/Nb)-Si-N, du fait de leur meilleure résistance à l'oxydation. De plus les dépôts en présence d'azote sont plus aisés à réaliser que les dépôts en présence d'acétylène ou de méthane.

Avantageusement, la teneur atomique en Si est comprise entre 1 et 15 %, et de préférence entre 1 et 5 %. Il est en effet apparu qu'un effet notable sur la réduction de l'apparition des taches sur les surfaces de cuisson, tel que précédemment évoqué, n'est apparent que pour des teneurs en Si supérieures à 1 % atomique , teneur minimale qui permet également aux revêtements de présenter une bonne résistance à la rayure. Par ailleurs, des teneurs trop élevées de Si génèrent une modification de la structure des couches obtenues qui peuvent dégrader les qualités obtenues pour des taux de Si inférieurs.

Selon un procédé préféré de réalisation, une couche de dépôt métallique de l'un ou plusieurs des constituants parmi Zr et/ou Nb et/ou Ti est réalisée avant la phase de carburation et/ou de nitruration, afin de renforcer l'adhésion entre le revêtement et le substrat.

De plus, le dépôt d'une couche métallique est plus rapide que le dépôt de cette même couche avec un gaz réactif, ce qui permet une plus grande vitesse de dépôt au global.

Afin d'optimiser les durées de traitement et le coût de ce revêtement, l'épaisseur du dépôt réalisé est comprise entre 2 et 10 µm.

Lorsque la technique de dépôt physique en phase vapeur est utilisée, la pulvérisation par processus physique est obtenue par l'application d'une différence de potentiel entre un substrat et une ou plusieurs cibles obtenues par assemblage sur un support conducteur d'une ou plusieurs tôle(s) ou plaque(s) de matériau ayant la composition recherchée, lesdites tôles ou plaques étant obtenues soit par laminage, soit par frittage de poudre ou projection thermique de poudre, soit issues de coulée. D'une manière générale, toutes les techniques de dépôt physique en phase vapeur peuvent être utilisées, comme par exemple l'évaporation par arc cathodique en conditions réactives.

Le substrat peut être composé d'une ou plusieurs tôle(s) métallique(s) des matériaux suivants : aluminium, cuivre, fonte, acier, notamment acier inoxydable.

La présente invention vise également un article culinaire destiné à la cuisson d'aliments, comportant une surface de cuisson telle que précédemment décrite. Un tel article culinaire peut être notamment une poêle, une casserole, un faitout, un wok,...

La présente invention porte également sur un appareil électroménager destiné à la cuisson d'aliments, comportant une surface de cuisson des moyens de chauffe électrique ou à gaz de ladite surface de cuisson, ladite surface de cuisson étant conforme à l'une des caractéristiques précédemment décrites. Un tel appareil électroménager peut être notamment un appareil de préparation culinaire chauffant, un appareil à raclette, un appareil à fondue, une friteuse, une machine à pain, un cuiseur à riz...

D'autres avantages issus des essais apparaîtront à la lecture de la description qui va suivre, en relation avec les figures annexées parmi lesquelles :
- La figure 1 est un relevé en diffractogramme de rayons X en incidence rasante de deux revêtements dont l'un est conforme à l'invention.
- Les figures 2 et 3 sont des fractographies vues au microscope électronique à balayage de deux revêtements dont l'un est conforme à l'invention.
- La figure 4 présente le résultat d'un essai de tenue à la rayure pour deux revêtements dont l'un est conforme à l'invention.
- La figure 5 est un relevé analogue à la figure 1 pour des revêtements différents de ceux présentés figure 1.
- Les figures 6 et 7 représentent des photographies illustrant l'une des propriétés de l'invention.

Le premier exemple d'illustration de la présente invention concerne le dépôt d'un revêtement NbN sur un substrat en acier inoxydable, après dégraissage et décapage ionique du substrat. La méthode d'élaboration est un dépôt en phase vapeur réactive où, après un vide poussé de l'enceinte, où ne subsiste essentiellement que de l'argon nécessaire à la réalisation du plasma, la pulvérisation de la cible métallique est réalisée en introduisant de l'azote dans le plasma d'argon afin que la pulvérisation de la cible métallique contenant le niobium permette l'obtention de nitrure de niobium NbN.

Différents paramètres d'élaboration peuvent être modifiés afin de faire varier la vitesse de dépôt (épaisseur du revêtement) et la qualité du dépôt, dans le but d'obtenir des couches suffisamment épaisses pour pouvoir être caractérisées, mais sans excès afin de conserver une bonne adhérence avec le substrat.

Le choix s'est porté sur l'utilisation d'un magnétron pour augmenter les vitesses de dépôt tout en permettant l'obtention de revêtements denses et purs par diminution de la pression dans l'enceinte.

Par ailleurs, l'influence du débit d'azote, notamment sur la vitesse de dépôt et la structure cristalline du revêtement a permis de trouver une plage de débit optimale pour l'obtention d'une vitesse de dépôt de l'ordre de 1,5 µm/h à 4 µm/h.

L'une des caractéristiques des couches est la mesure de leurs épaisseurs, à l'aide d'un profilomètre qui permet de retranscrire sur papier, après amplification, les mouvements d'un stylet se déplaçant sur la surface du revêtement, un décrochement brusque signifiant que le stylet est en contact avec le substrat. La mesure de ce décrochement, après calibration ou abaques, permet de mesurer l'épaisseur du revêtement. Des résultats similaires peuvent être obtenus en utilisant un profilomètre non tactile. Cette mesure est complétée par une analyse en section transverse par microscopie électronique à balayage. Enfin, la mesure d'épaisseur du revêtement peut être pratiquée par toutes autres méthodes permettant de mesurer précisément l'épaisseur de revêtements micrométriques comme par exemple la méthode du « Calotest »® ou par observation par microscopie optique d'une coupe ou d'une fracture du revêtement.

Une autre mesure concerne l'analyse chimique du revêtement, obtenue soit par microsonde de Castaing, soit par spectrométrie à dispersion d'énergie de photons X couplée à un microscope électronique à balayage, où l'on observe la désexcitation des électrons issus du revêtement après le bombardement électronique, indiquant ainsi la nature de l'électron excité, soit par diffraction des rayons X en configuration Bragg-Brentanno, permettant d'identifier les différentes phases cristallines de la couche.

Les propriétés mécaniques, et notamment la tenue à la rayure, sont déterminées par un appareil communément appelé « micro scratch testeur » qui consiste à appliquer une pointe de diamant dont le rayon de courbure est typiquement compris entre quelques micromètres et plusieurs dizaines de micromètres sur la surface du revêtement en déplacement, sous une charge progressive de 0,1 à 5 N. Différents capteurs équipant l'appareil permettent notamment de déterminer la profondeur de pénétration ainsi que le coefficient de frottement.

Selon l'invention, une cible de silicium est introduite dans le réacteur d'élaboration. Différents dépôts ont été réalisés en conservant les paramètres optimisés pour le dépôt de NbN tel que précédemment évoqué. Seule l'intensité sur la cible de silicium a évolué afin de modifier la teneur en Si des différents revêtements.

Cette teneur en Si des différents revêtements est mesurée selon les mêmes techniques que celles citées ci-dessus.

En supposant que le composé NbN est stoechiométrique, le rapport Si/Nb permet de remonter à la concentration atomique en Si, et donc éventuellement à la concentration massique de Si, après détermination des composés en présence.

Les analyses sur les différents revêtements obtenus montrent que le revêtement devient de plus en plus finement cristallisé lorsque le taux de Si augmente.

Concernant la tenue à l'oxydation des différents revêtements avec apport de Si, tous les dépôts ont subi une étape de recuit à une température de 500 °C, pendant deux heures afin d'observer le niveau d'oxydation des revêtements, en comparaison avec un revêtement NbN ayant subi le même recuit.

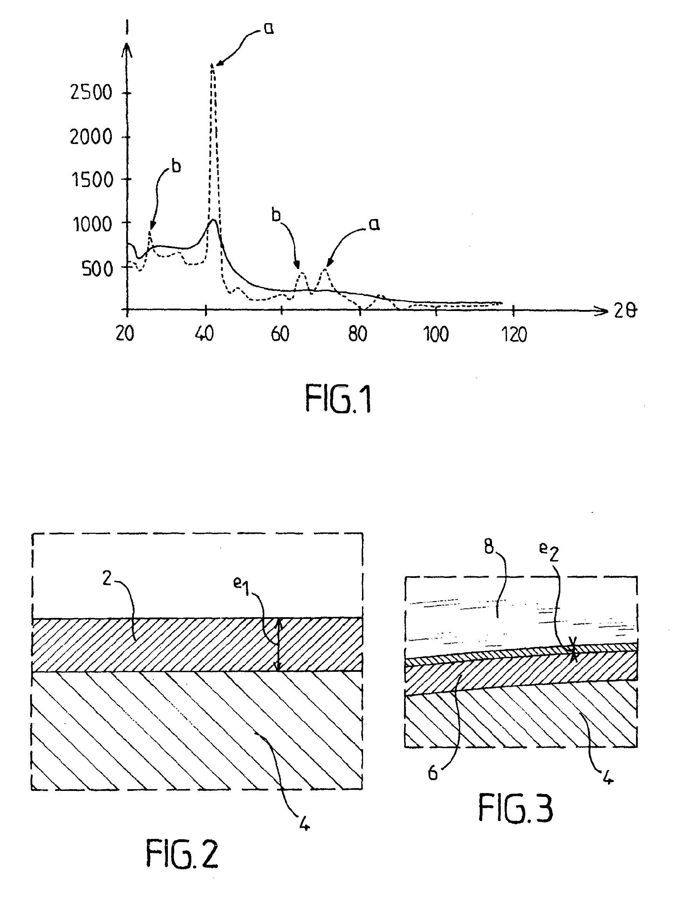

La figure 1 montre le relevé d'une diffraction des rayons X en incidence rasante, pour un substrat en acier inoxydable sur lequel un revêtement de NbN a été déposé (courbe pointillée) et pour un substrat en acier inoxydable sur lequel un revêtement de Nb-Si-N a été déposé, le rapport Si/Nb atomique étant de 0,27 (courbe en trait plein), les deux échantillons ayant subi un recuit tel que précédemment évoqué.

Sur ces relevés, les pics référencés « a » correspondent au composé NbN, tandis que les pics « *b »* correspondent à un oxyde de niobium.

Il ressort donc de la confrontation des deux courbes que l'ajout de silicium permet de réduire considérablement la présence d'oxydes en surface, l'intensité des pics relatifs à l'oxyde de niobium diminuant fortement lorsque du silicium est ajouté dans le revêtement à base de NbN. La résistance à l'oxydation est donc améliorée.

L'observation en coupe au microscope électronique à balayage en mode électrons secondaires de ces deux revêtements NbN et Nb-Si-N après recuit, respectivement illustrés figures 2 et 3, confirme les courbes précédentes. En effet, l'épaisseur e₁ d'oxyde sur le revêtement 2 en NbN correspond en fait à l'épaisseur totale du revêtement, le composé sous-jacent 4 étant le substrat, cette épaisseur d'oxyde étant bien plus importante que pour le revêtement 6 en Nb-Si-N qui n'est oxydé qu'en surface, sur une épaisseur e₂. Le revêtement 6 forme ainsi une surface de cuisson 8 selon l'invention. La surface de cuisson 8 consiste ainsi en un dépôt de Nb-Si-N.

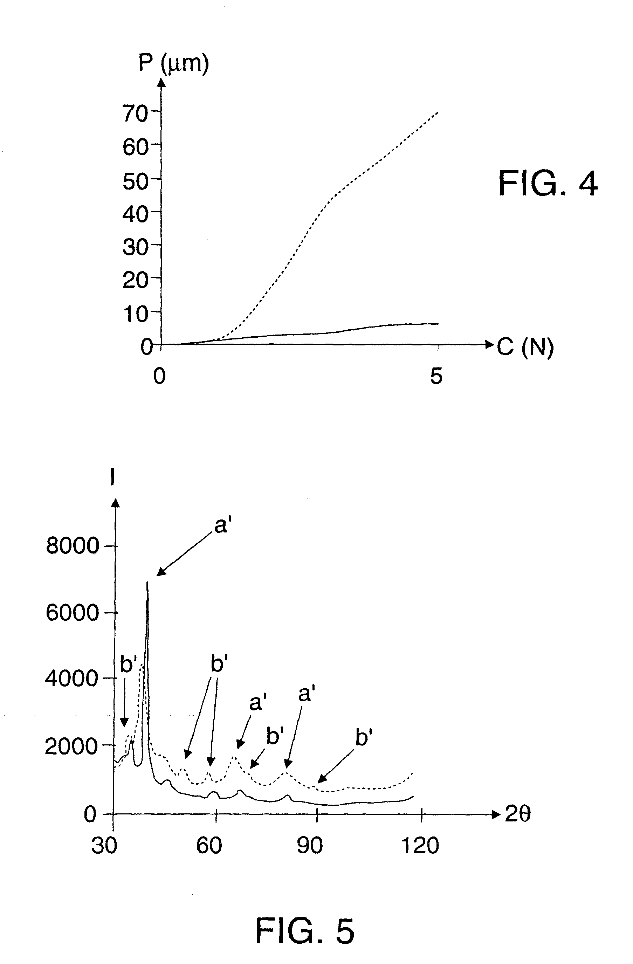

De plus, des essais de tenue à la rayure ont démontré que l'apport de silicium améliore la dureté ainsi que les propriétés d'adhésion du revêtement sur le substrat. En effet, la figure 4 montre la profondeur de pénétration de la pointe de diamant de l'appareil dans le revêtement en fonction de la charge appliquée. La courbe en pointillé correspond à un revêtement de NbN tandis que la courbe pleine est relative à un revêtement Nb-Si-N avec un taux de Si de 4 % atomique. Il ressort clairement que l'ajout de Si permet d'augmenter considérablement la dureté, et ce même pour des taux de Si assez faibles, de l'ordre de 1 % atomique.

Les informations enregistrées par les différents capteurs au cours de ce test ont permis également de constater une amélioration de l'adhérence du film pour des teneurs en Si supérieures à 1 % atomique.

Afin de déterminer la faculté de facilité de nettoyage des revêtements lorsque ces revêtements sont utilisés en tant que surface de cuisson, différents essais de cuisson selon la méthode telle que développée dans les demandes précédemment citées au nom du déposant ont été conduits avant le test au plynomètre.

Le substrat est toutefois constitué de trois couches successives d'acier inoxydable ferritique, d'aluminium et d'acier inoxydable austénitique, toutes ces couches présentant une épaisseur de 0,4 mm. Avant le dépôt du revêtement choisi, une couche de niobium pur est effectuée sur une épaisseur de 1 µm afin d'assurer une bonne adhérence entre le substrat et le revêtement.

Le revêtement est ensuite déposé sur une épaisseur suffisante (environ 3 µm) avant de subir la cuisson et le test de facilité de nettoyage réalisé par un plynomètre.

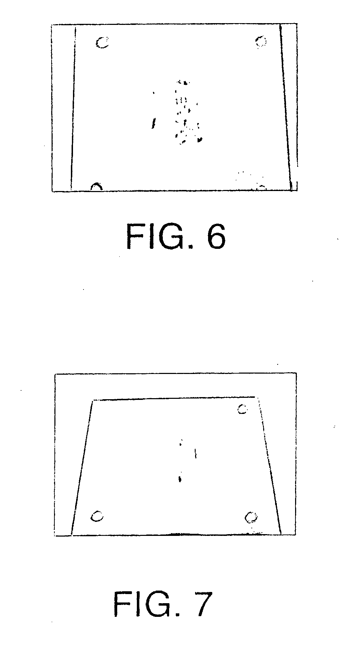

De tels essais, illustrés figures 6 et 7, montrent de façon concluante et inattendue que les revêtements de NbN dopés au silicium, illustrés sur la figure 7, présentent une aptitude supérieure de facilité de nettoyage que les revêtements de NbN seuls, illustrés sur la figure 6.

Cet aspect est d'autant plus inattendu qu'il est associé à une amélioration d'autres propriétés du revêtement, et notamment l'atténuation, voire la disparition des taches d'oxydation.

Ainsi, l'ajout de silicium lors d'un dépôt de NbN permet audit dépôt :
- d'augmenter sa tenue à l'oxydation,
- d'augmenter sa dureté,
- d'améliorer sa propriété d'adhésion au substrat,
- une meilleure cohésion.
- d'augmenter sa propriété de facilité de nettoyage.

Par ailleurs, les couleurs initialement obtenues par un dépôt de NbN seul ne sont pas modifiées par l'ajout de silicium.

Le second exemple de mise en oeuvre de la présente invention concerne le dépôt d'un revêtement de ZrN et l'influence d'un ajout de silicium. La surface de cuisson consiste ainsi en un dépôt de Zr-Si-N.

Tout comme pour le niobium, la première étape a consisté à déterminer les meilleures conditions de dépôt de ZrN, avant l'élaboration de composés Zr-Si-N.

Ensuite, le même procédé opératoire que pour le Nb a été effectué, différents essais ayant été conduits en faisant varier la teneur en Si du revêtement, les différents revêtements obtenus ayant été ensuite caractérisés.

Il a également été constaté qu'un apport de Si entraîne un élargissement des pics de diffraction X, tendant ainsi à montrer que la structure devient plus finement cristallisée lorsque le taux de silicium augmente.

La figure 5, à l'instar de la figure 1, montre le relevé d'une diffraction des rayons X en incidence rasante, pour un substrat en acier inoxydable sur lequel un revêtement de ZrN a été déposé (courbe pointillée) et pour un substrat en acier inoxydable sur lequel un revêtement de Zr-Si-N a été déposé, le rapport Si/Zr atomique étant de 0,04 (courbe en trait plein), correspondant à une teneur de 2 % atomique de Si, en supposant le composé ZrN stoechiométrique, ces revêtements ayant subi au préalable de la mesure un traitement thermique dans l'air à 500°C pendant deux heures.

Les pics « a' » correspondent au composé ZrN, tandis que les pics « b' » correspondent au composé ZrO₂. Comme pour le cas du niobium, L'ajout de silicium permet d'améliorer la tenue à l'oxydation des couches réalisées.

En ce qui concerne la dureté, l'ajout de silicium a peu d'effet. Les revêtements ZrN présentent de bonnes propriétés de dureté, une pénétration de 9.7 µm sous 5N étant par exemple obtenue avec un test de dureté utilisant une pointe de diamant. L'ajout de silicium contribue à diminuer légèrement les propriétés de dureté, une pénétration de 10,5 µm sous 5N étant obtenue pour le revêtement Zr-Si-N à 2 % at. de Si, et une pénétration de 12,5 µm sous 5N étant obtenue pour le revêtement Zr-Si-N à 4 % at. de Si.

Le revêtement de ZrN seul est un revêtement présentant une bonne « facilité de nettoyage », et l'ajout de silicium augmente peu cette propriété.

Les taches, déjà moins présentes sur les revêtements ZrN que sur les revêtements NbN, disparaissent lors du dopage des revêtements par du silicium.

La présente invention n'est pas limitée aux exemples de réalisation mentionnés.

A titre de variante, les revêtements dopés par du silicium pourraient être du TiN au lieu de ZrN ou NbN.

A titre de variante, la présente invention porte également sur l'élaboration de revêtements qui ne sont pas uniquement en nitrure de zirconium ou en nitrure de niobium, mais à base d'une combinaison de Nb et/ou Zr et/ou Ti, dans le but d'augmenter la dureté et/ou de modifier la couleur du revêtement.

De plus, l'ajout de Si est également bénéfique lorsque le dépôt est réalisé avec des gaz réactifs différents ou supplémentaires, comme par exemple l'acétylène ou le méthane, afin de réaliser des carbures ou des carbonitrures.

La présente invention porte ainsi sur une surface de cuisson 8 d'aliments pour article culinaire ou appareil électroménager de cuisson, consistant en un dépôt de Zr et/ou Nb et/ou Ti sur un substrat 4, l'élaboration comportant une étape de carburation et/ou de nitruration d'au moins l'un des éléments, la surface comportant également un dépôt de Si afin de réaliser des revêtements 6 (Zr/Nb/Ti)-Si-(N/C). Le dépôt de Zr et/ou Nb et/ou Ti est avantageusement réalisé en condition réactive afin d'accomplir, pendant l'étape de dépôt, l'étape de carburation et/ou de nitruration. Le dépôt de Si peut être réalisé dans la même étape de dépôt que le dépôt de Zr et/ou Nb et/ou Ti. Une couche de dépôt métallique de l'un ou plusieurs des constituants parmi Zr, Nb ou Ti peut être réalisée avant la phase de carburation et/ou de nitruration. Avantageusement l'épaisseur du dépôt réalisé est comprise entre 2 et 10 µm.

## Revendications

1. Surface de cuisson (8) d'aliments pour article culinaire ou appareil électroménager de cuisson, consistant en un dépôt de Zr et/ou Nb et/ou Ti sur un substrat (4), sous forme de carbures, nitrures ou carbonitrures pour au moins l'un des éléments, **caractérisée en ce que** la surface de cuisson (8) comporte également un dépôt de Si afin de réaliser des revêtements (6) (Zr/Nb/Ti)-Si-(N/C).

2. Surface de cuisson (8) selon la revendication 1, **caractérisée en ce que** les dépôts sont réalisés par dépôt physique en phase vapeur.

3. Surface de cuisson (8) selon la revendication 2, **caractérisée en ce que** le dépôt est réalisé en condition réactive afin d'accomplir, pendant l'étape de dépôt, l'étape de carburation et/ou de nitruration.

4. Surface de cuisson (8) selon l'une des revendications 1 à 3, **caractérisée en ce que** le dépôt de Si est réalisé dans la même étape de dépôt que le dépôt de Zr et/ou Nb et/ou Ti.

5. Surface de cuisson (8) selon l'une des revendications 1 à 4, **caractérisée en ce qu'**elle consiste en un dépôt de (Zr/Nb)-Si-N.

6. Surface de cuisson (8) selon l'une des revendications 1 à 5, **caractérisée en ce que** la teneur atomique en Si est comprise entre 1 et 15 %, et de préférence entre 1 et 5 %.

7. Surface de cuisson (8) selon l'une des revendications 1 à 6, **caractérisée en ce qu'**une couche de dépôt métallique de l'un ou plusieurs des constituants parmi Zr, Nb ou Ti est réalisée avant la phase de carburation et/ou de nitruration.

8. Surface de cuisson (8) selon l'une des revendications 1 à 7, **caractérisée en ce que** l'épaisseur du dépôt réalisé est comprise entre 2 et 10 µm.

9. Surface de cuisson (8) selon l'une des revendications 2 à 8 lorsque dépendant de l'une des revendications 2 ou 3, **caractérisée en ce que** le dépôt est réalisé à partir d'une ou plusieurs cibles obtenues par assemblage sur un support conducteur d'une ou plusieurs tôle(s) ou plaque(s) de matériau ayant la composition recherchée, lesdites tôles ou plaques étant obtenues soit par laminage, soit par frittage de poudre ou projection thermique de poudre, soit issues de coulée.

10. Surface de cuisson (8) selon l'une des revendications 1 à 9, **caractérisée en ce que** le substrat (4) est composé d'une ou plusieurs tôle(s) métallique(s) des matériaux suivants : aluminium, cuivre, fonte, acier, notamment acier inoxydable.

11. Article culinaire destiné à la cuisson d'aliments, **caractérisé en ce qu'**il comporte une surface de cuisson (8) selon l'une des revendications 1 à 10.

12. Appareil électroménager destiné à la cuisson d'aliments, comportant une surface de cuisson (8) et des moyens de chauffe électrique ou à gaz de ladite surface de cuisson (8), **caractérisé en ce que** ladite surface de cuisson (8) est conforme à l'une des revendications 1 à 10.

13. Procédé de réalisation d'une surface de cuisson (8) d'aliments pour article culinaire ou appareil électroménager de cuisson, consistant à réaliser sur un substrat (4) un dépôt par PVD de Zr et/ou Nb et/ou Ti contenant également du Si, l'élaboration comportant une étape de carburation et/ou de nitruration d'au moins l'un des éléments Zr et/ou Nb et/ou Ti, afin de réaliser des revêtements (6) (Zr/Nb/Ti)-Si-(N/C).

14. Procédé de réalisation d'une surface de cuisson (8) d'aliments selon la revendication 13, **caractérisé en ce que** le dépôt est réalisé en condition réactive afin d'accomplir, pendant l'étape de dépôt, l'étape de carburation et/ou de nitruration.

15. Procédé de réalisation d'une surface de cuisson (8) d'aliments selon l'une des revendications 13 ou 14, **caractérisé en ce que** le dépôt de Si est réalisé dans la même étape de dépôt que le dépôt de Zr et/ou Nb et/ou Ti.

16. Procédé de réalisation d'une surface de cuisson (8) d'aliments selon l'une des revendications 13 à 15, **caractérisé en ce qu'**une couche de dépôt métallique de l'un ou plusieurs des constituants parmi Zr, Nb ou Ti est réalisée avant la phase de carburation et/ou de nitruration.

17. Procédé de réalisation d'une surface de cuisson (8) d'aliments selon l'une des revendications 13 à 16, **caractérisé en ce que** le dépôt est réalisé à partir d'une ou plusieurs cibles obtenues par assemblage sur un support conducteur d'une ou plusieurs tôle(s) ou plaque(s) de matériau ayant la composition recherchée, lesdites tôles ou plaques étant obtenues soit par laminage, soit par frittage de poudre ou projection thermique de poudre, soit issues de coulée.

## Patentansprüche

1. Kochplatte (8) für Küchenartikel oder elektrische Haushaltsgargeräte, bestehend aus einer Schicht aus Zr und/oder Nb und/oder Ti auf einem Substrat (4), in Form von Carbiden, Nitriden oder Carbonitriden für mindestens eines der Elemente, **dadurch gekennzeichnet, dass** die Kochplatte (8) ebenfalls eine Schicht aus Si umfasst, um die Beschichtung (6) (Zr/Nb/Ti)-Si-(N/C) herzustellen.

2. Kochplatte (8) nach Anspruch 1, **dadurch gekennzeichnet, dass** die Schichten durch physikalischen Dampfniederschlag hergestellt werden.

3. Kochplatte (8) nach Anspruch 2, **dadurch gekennzeichnet, dass** die Schicht im reaktiven Zustand hergestellt wird, um während des Niederschlagsprozesses den Karburierungs- und/oder Nitriervorgang auszuführen.

4. Kochplatte (8) nach einem der Ansprüche 1 bis 3, **dadurch gekennzeichnet, dass** die Si-Schicht während desselben Niederschlagsprozesses hergestellt wird wie die Schicht aus Zr und/oder Nb und/oder Ti.

5. Kochplatte (8) nach einem der Ansprüche 1 bis 4, **dadurch gekennzeichnet, dass** sie aus einer Schicht aus (Zr/Nb)-Si-N besteht.

6. Kochplatte (8) nach einem der Ansprüche 1 bis 5, **dadurch gekennzeichnet, dass** der Gehalt an Si-Atomen zwischen 1 und 15 % liegt, vorzugsweise jedoch zwischen 1 und 5 %.

7. Kochplatte (8) nach einem der Ansprüche 1 bis 6, **dadurch gekennzeichnet, dass** eine Metallabscheidungsschicht aus einem oder mehreren der Bestandteile Zr, Nb oder Ti vor dem Karburierungs- und/oder Nitriervorgang hergestellt wird.

8. Kochplatte (8) nach einem der Ansprüche 1 bis 7, **dadurch gekennzeichnet, dass** die hergestellte Schicht zwischen 2 und 10 µm dick ist.

9. Kochplatte (8) nach einem der Ansprüche 2 bis 8, in Abhängigkeit von einem der Ansprüche 2 oder 3, **dadurch gekennzeichnet, dass** die Schicht ausgehend von einem oder mehreren Auffängern hergestellt wird, die aus einer Verbindung von einem/einer oder mehreren Blech(en) oder Platte(n) aus einem Material mit der benötigten Zusammensetzung auf einem leitenden Träger entstehen, wobei die besagten Bleche oder Platten durch Walzen, Pulversintern oder Pulverflammspritzen oder aber durch Gießen hergestellt werden.

10. Kochplatte (8) nach einem der Ansprüche 1 bis 9, **dadurch gekennzeichnet, dass** das Substrat (4) aus einer oder mehreren Metallplatten aus folgenden Materialien besteht: Aluminium, Kupfer, Gusseisen, Stahl, insbesondere rostfreiem Stahl.

11. Küchenartikel zum Garen von Lebensmitteln, **dadurch gekennzeichnet, dass** er eine Kochplatte (8) nach einem der Ansprüche 1 bis 10 umfasst.

12. Haushaltsgerät zum Garen von Lebensmitteln, das eine Kochplatte (8) und elektrische oder gasbetriebene Heizmittel für die besagte Kochplatte (8) umfasst, **dadurch gekennzeichnet, dass** die Kochplatte (8) einem der Ansprüche 1 bis 10 entspricht.

13. Verfahren zur Herstellung einer Kochplatte (8) für Küchenartikel oder elektrische Haushaltsgargeräte, das darin besteht, auf einem Substrat (4) eine PVD-Schicht aus Zr und/oder Nb und/oder Ti herzustellen, die ebenfalls Si enthält, wobei die Bearbeitung einen Karburierungs- und/oder Nitriervorgang mit mindestens einem der Elemente Zr und/oder Nb und/oder Ti umfasst, um die Beschichtungen (6) (Zr/Nb/Ti)-Si-(N/C) herzustellen.

14. Verfahren zur Herstellung einer Kochplatte (8) nach Anspruch 13, **dadurch gekennzeichnet, dass** die Schicht im reaktiven Zustand hergestellt wird, um während des Niederschlagsprozesses den Karburierungs- und/oder Nitriervorgang auszuführen.

15. Verfahren zur Herstellung einer Kochplatte (8) nach einem der Ansprüche 13 oder 14, **dadurch gekennzeichnet, dass** die Si-Schicht während desselben Niederschlagsprozesses hergestellt wird wie die Schicht aus Zr und/oder Nb und/oder Ti.

16. Verfahren zur Herstellung einer Kochplatte (8) nach einem der Ansprüche 13 bis 15, **dadurch gekennzeichnet, dass** eine Metallabscheidungsschicht aus einem oder mehreren der Bestandteile Zr, Nb oder Ti vor dem Karburierungs- und/oder Nitriervorgang hergestellt wird.

17. Verfahren zur Herstellung einer Kochplatte (8) nach einem der Ansprüche 13 bis 16, **dadurch gekennzeichnet, dass** die Schicht ausgehend von einem oder mehreren Auffängern hergestellt wird, die aus einer Verbindung von einem/einer oder mehreren Blech(en) oder Platte(n) aus einem Material mit der benötigten Zusammensetzung auf einem leitenden Träger entstehen, wobei die besagten Bleche oder Platten durch Walzen, Pulversintern oder Pulverflammspritzen oder aber durch Gießen hergestellt werden.

## Claims

1. Food-cooking surface (8) for a culinary article or a domestic electrical cooking appliance, consisting of a deposit of Zr and/or Nb and/or Ti on a substrate (4), in the form of carbides, nitrides or carbonitrides for at least one of the elements, **characterised in that** the cooking surface (8) also includes a deposit of Si so as to produce (Zr/Nb/Ti)-Si-(N/C) coatings (6).

2. Cooking surface (8) according to claim 1, **characterised in that** the deposits are produced by physical vapour deposition.

3. Cooking surface (8) according to in claim 2, **characterised in that** the deposition is reactive so as to accomplish the carburising and/or nitriding step during the deposition step.

4. Cooking surface (8) according to one of claims 1 to 3, **characterised in that** Si is deposited in the same deposition step as the deposition of Zr and/or Nb and/or Ti.

5. Cooking surface (8) according to one of claims 1 to 4, **characterised in that** it consists of a deposit of (Zr/Nb)-Si-N.

6. Cooking surface (8) according to one of claims 1 to 5, **characterised in that** the Si content is between 1 and 15 at. %, and preferably between 1 and 5 at. %.

7. Cooking surface (8) according to one of claims 1 to 6, **characterised in that** a metal deposit layer of one or more of the constituents Zr, Nb, or Ti is produced prior to the carburising and/or nitriding phase.

8. Cooking surface (8) according to one of claims 1 to 7, **characterised in that** the thickness of the deposit produced is between 2 and 10 µm.

9. Cooking surface (8) according to one of claims 2 to 8 when depending from claim 2 or claim 3, **characterised in that** the deposit is produced from one or more targets obtained by assembly of one or more sheets or plates of material with the desired composition on a conductive surface, said sheets or plates being obtained by lamination, powder sintering, thermal powder spraying, or casting.

10. Cooking surface (8) according to one of claims 1 to 9, **characterised in that** the substrate (4) is composed of one or more metal sheets of the following materials: aluminium, copper, cast iron, steel, in particular stainless steel.

11. Culinary article for cooking food, **characterised in that** it comprises a cooking surface (8) according to one of claims 1 to 10.

12. Domestic electrical appliance for cooking food, comprising a cooking surface (8) and electric or gas-powered means for heating said cooking surface (8), **characterised in that** said cooking surface (8) complies with one of claims 1 to 10.

13. Method for manufacturing a food-cooking surface (8) for a culinary article or a domestic electrical cooking appliance, which consists in producing on a substrate (4) a deposit by PVD of Zr and/or Nb and/or Ti, also containing Si, the elaboration comprising a step of carburising and/or nitriding of at least one of the elements Zr and/or Nb and/or Ti, so as to produce (Zr/Nb/Ti)-Si-(N/C) coatings (6).

14. Method for manufacturing a food-cooking surface (8) as in claim 13, **characterised in that** the deposition is reactive so as to accomplish the carburising and/or nitriding step during the deposition step.

15. Method for manufacturing a food-cooking surface (8) as in claim 13 or 14, **characterised in that** Si is deposited in the same deposition step of depositing Zr and/or Nb and/or Ti.

16. Method for manufacturing a food-cooking surface (8) according to any of claims 13 to 15, **characterised in that** a metal deposit layer of one or more of the constituents Zr, Nb, or Ti is produced prior to the carburising and/or nitriding phase.

17. Method for manufacturing a food-cooking surface (8) according to any of claims 13 to 16, **characterised in that** the deposit is produced from one or more targets obtained by assembly of one or more sheets or plates of material with the desired composition on a conductive surface, said sheets or plates being obtained by lamination, powder sintering, thermal powder spraying, or casting.
